# EUROPEAN PATENT APPLICATION

(11) **EP 4 465 805 A1**
(43) Date of publication of application: **20.11.2024**
(21) Application number: 24165855.8
(22) Date of filing: 25.03.2024
(51) Int. Cl.: H10N 97/00

(54) **CAPACITOR AND SEMICONDUCTOR DEVICE INCLUDING THE SAME**

(30) Priority: 16.05.2023 KR 20230062780
(71) Applicant: Samsung Electronics Co., Ltd., Suwon-si, Gyeonggi-do 16677 (KR)
(72) Inventor: JUNG, Kyooho, 16677 Suwon-si (KR); MIN, Jongyeong, 16677 Suwon-si (KR); BAEK, Jiye, 16677 Suwon-si (KR); PARK, Joonsuk, 16677 Suwon-si (KR); LEE, Yeseul, 16677 Suwon-Si (KR); LEE, Jinwook, 16677 Suwon-si (KR)
(74) Representative: Marks & Clerk LLP

(57) **Abstract**

A capacitor may include a primary lower electrode, an interface structure on a surface of the primary lower electrode, a primary dielectric layer including a metal oxide on the interface structure, and an upper electrode on the primary dielectric layer. The interface structure may include a first interface layer, a second interface layer, and a third interface layer. The first interface layer may have electrical conductivity, and may include a metal oxide doped with a pentavalent element. The second interface layer may be on the first interface layer, and may include a material further doped with nitrogen in the material of the first interface layer. The third interface layer may be on the second interface layer, and may include a metal oxide doped with nitrogen. A metal included in the metal oxide of the third interface layer may include a tetravalent metal.

## Description

### BACKGROUND

### 1. Field

Example embodiments relate to a capacitor. Particularly, example embodiments relate to a semiconductor device including the capacitor.

### 2. Description of the Related Art

A capacitor included in a semiconductor device may be required to have high electrostatic capacitance. To this end, a thickness of a dielectric layer of the capacitor may be decreased. However, as the thickness of the dielectric layer of the capacitor is decreased, leakage currents of the capacitor may be increased. Therefore, it is difficult for the capacitor to have high capacitance and low leakage currents.

### SUMMARY

Example embodiments provide a capacitor having excellent electrical characteristics.

Example embodiments provide a semiconductor device including a capacitor having excellent electrical characteristics.

Example embodiments provide a method for forming a capacitor having excellent electrical characteristics.

According to example embodiments, there is provided a capacitor. The capacitor may include a primary lower electrode, an interface structure on a surface of the primary lower electrode, a primary dielectric layer including a first metal oxide on the interface structure, and an upper electrode on the primary dielectric layer. The interface structure may include a first interface layer, a second interface layer, and a third interface layer. The first interface layer may have electrical conductivity, and may include a second metal oxide doped with a pentavalent element. The second interface layer may be on the first interface layer, and may include a material further doped with nitrogen in the material of the first interface layer. The third interface layer may be on the second interface layer, and may include a third metal oxide doped with nitrogen. A metal included in the third metal oxide of the third interface layer may include a tetravalent metal.

According to example embodiments, there is provided a semiconductor device. The semiconductor device may include primary conductive patterns and an etch stop layer on a substrate, primary lower electrodes passing through the etch stop layer, and contacting the conductive patterns, respectively, a first interface layer contacting surfaces of the primary lower electrodes, and including titanium oxide doped with a pentavalent element, a second interface layer on the first interface layer, and including titanium oxide doped with a pentavalent element and nitrogen, and a third interface layer on the second interface layer and the etch stop layer, and including a metal oxide doped with nitrogen, a primary dielectric layer including a metal oxide including a tetravalent metal on the third interface layer and an upper electrode on the dielectric layer. A metal included in the metal oxide of the third interface layer may include a tetravalent metal.

According to example embodiments, there is provided a semiconductor device. The semiconductor device may include a cell transistor including a gate structure on a substrate, a bit line structure electrically connected to a portion of the substrate, conductive patterns on the bit line structure and being electrically connected to a portion of the substrate, and a capacitor on each of the conductive patterns. The capacitor may include a primary lower electrode contacting corresponding one of the conductive patterns, an interface structure on the surface of the primary lower electrode, a primary dielectric layer on the interface structure, the primary dielectric layer including a metal oxide including a tetravalent metal, and an upper electrode on the primary dielectric layer. The interface structure may include a first interface layer, a second interface layer, and a third interface layer sequentially stacked. The primary dielectric layer may include a metal oxide including a tetravalent metal. The first and second interface layers may include a conductive metal oxide, and the third interface layer may include a nitrogen-doped metal oxide including a different metal from the first and second interface layers.

According to example embodiments, there is provided a semiconductor device. The semiconductor device may include a substrate, conductive patterns on the substrate, and a capacitor on each of the conductive patterns. Each capacitor may include a primary lower electrode contacting a corresponding one of the conductive patterns, an interface structure on a surface of the primary lower electrode, a primary dielectric layer on the interface structure, the primary dielectric layer including a first metal oxide, and an upper electrode on the primary dielectric layer. The interface structure may include a first interface layer on the primary lower electrode, a second interface layer on the first interface layer, and a third interface layer on the second interface layer. The first interface layer may include a second metal oxide. The second interface layer may include the second metal oxide. The third interface layer may include a third metal oxide. The primary lower electrode, the first interface layer and the second interface layer may function as an electrode of the capacitor, and the third interface layer and the primary dielectric layer may function as a dielectric of the capacitor. Each of the first interface layer and the second interface layer may be a part of a monolithic layer, and a nitrogen concentration of the second interface layer may be higher than a nitrogen concentration of the first interface layer. A nitrogen concentration of the third interface layer may be higher than a nitrogen concentration of the primary dielectric layer.

According to example embodiments, there is provided a method for forming a capacitor. The method may include forming a primary lower electrode including metal on a substrate; forming a first preliminary interface layer including a first metal oxide doped with a pentavalent element on a surface of the primary lower electrode; forming a second preliminary interface layer including a second metal oxide including a tetravalent metal on the first preliminary interface layer; doping nitrogen into the second preliminary interface layer and an upper portion of the first preliminary interface layer to form an interface structure including a first interface layer including the first metal oxide doped with the pentavalent element on the surface of the primary lower electrode, a second interface layer including the first metal oxide further doped with the pentavalent element and nitrogen, and a third interface layer including a third metal oxide of a tetravalent metal doped with nitrogen; forming a primary dielectric layer on the interface structure; and forming an upper electrode on the primary dielectric layer.

The capacitor structure according to example embodiments may include the interface layer structure between the primary lower electrode and the primary dielectric layer, so that leakage currents generated between the primary lower electrode and the primary dielectric layer may be decreased.

At least some of the above and other features of the invention are set out in the claims.

### BRIEF DESCRIPTION OF THE DRAWINGS

Example embodiments will be more clearly understood from the following detailed description taken in conjunction with the accompanying drawings. FIGS. 1 to 27 represent non-limiting, example embodiments as described herein.
FIG. 1 is a cross-sectional view illustrating a capacitor according to example embodiments;
FIG. 2 is an enlarged cross-sectional view of the capacitor shown in FIG. 1;
FIGS. 3 to 11 are cross-sectional views for illustrating a method of forming a capacitor according to example embodiments;
FIG. 12 is a cross-sectional view illustrating capacitors according to example embodiments;
FIGS. 13 to 18 are cross-sectional views illustrating a method of forming a capacitor according to example embodiments;
FIG. 19 is a plan view illustrating a layout of a semiconductor device according to example embodiments;
FIG. 20 is a cross-sectional view of a semiconductor device according to example embodiments;
FIGS. 21 and 22 are cross-sectional views illustrating a method for manufacturing a semiconductor device according to example embodiments;
FIG. 23 is a layout illustrating a semiconductor device according to example embodiments;
FIG. 24 is cross-sectional views illustrating a semiconductor device according to example embodiments;
FIG. 25 is a cross-sectional view of a semiconductor device according to example embodiments;
FIG. 26 is a plan view illustrating a semiconductor device according to example embodiments; and
FIG. 27 is a graph of capacitances and leakage current characteristics of a capacitor according to an embodiment and a capacitor according to a comparative example.

### DETAILED DESCRIPTION OF THE EMBODIMENTS

Hereinafter, preferred embodiments of the present invention will be described in detail with reference to the accompanying drawings.

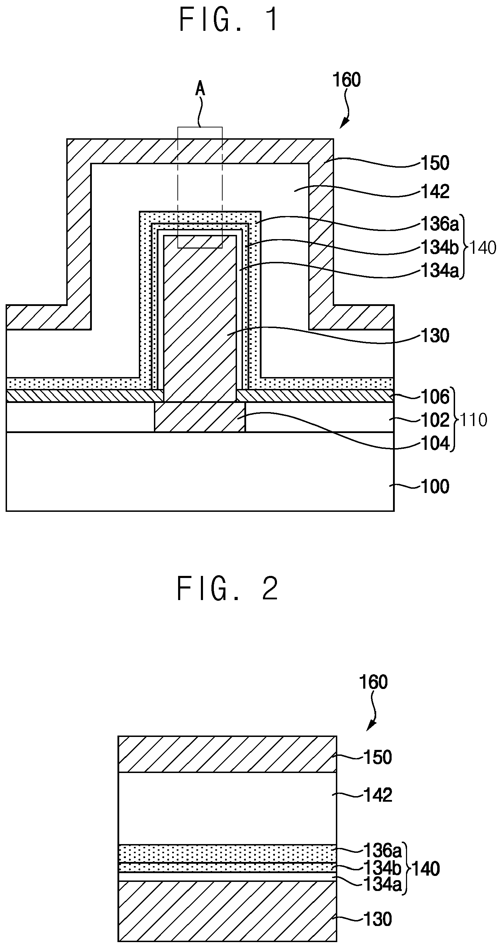

FIG. 1 is a cross-sectional view illustrating a capacitor according to example embodiments, and FIG. 2 is an enlarged cross-sectional view of the capacitor shown in FIG. 1.

FIG. 1 is a vertical cross-sectional view of the capacitor having a primary lower electrode having pillar-shape. FIG. 2 is an enlarged cross-sectional view of a portion A of FIG. 1.

Referring to FIGS. 1 and 2, the capacitor 160 may include a primary lower electrode 130, an interface structure 140, a primary dielectric layer 142, and an upper electrode 150.

In example embodiments, the capacitor 160 may be formed on a lower structure 110 formed on a substrate 100. The lower structure 110 may include, e.g., a transistor, a contact plug, a conductive pattern 104, a conductive line, an insulating interlayer 102, and an etch stop layer 106. The conductive pattern 104 may contact a bottom surface of the primary lower electrode 130. The etch stop layer 106 may be formed on the conductive pattern 104 and the insulating interlayer 102.

The substrate 100 may include, e.g., a semiconductor material such as silicon, germanium, silicon-germanium, etc., or a group III-V compound such as GaP, GaAs, GaSb, etc. In some example embodiments, the substrate 100 may be a silicon-on-insulator (SOI) substrate or a germanium-on-insulator (GOI) substrate.

The primary lower electrode 130 may pass through the etch stop layer 106, and may contact an upper surface of the conductive pattern 104.

The primary lower electrode 130 may include or be formed of metal or metal nitride. In example embodiments, the primary lower electrode 130 may include or be formed of titanium nitride (TiN), titanium (Ti), titanium silicon nitride (TiSiN), tantalum (Ta), tantalum nitride (TaN), or tantalum silicon nitride (TaSiN). For example, the primary lower electrode 130 may be titanium nitride (TiN).

The primary lower electrode 130 may have various three-dimensional structures.

In example embodiments, the primary lower electrode 130 may have a three-dimensional structure such as a cylindrical shape or pillar shape. As shown in FIG. 1, the primary lower electrode 130 may have a pillar shape. Alternatively, the primary lower electrode may have a cylindrical shape (i.e., a cup shape).

In example embodiments, the primary lower electrode 130 may have a flat two-dimensional shape (e.g., a planar shape when viewed in a cross-section). In this case, the capacitor may have a shape similar to an enlarged view shown in FIG. 2. Since a capacitance of the capacitor is determined by a surface area of the primary lower electrode 130, a shape of the primary lower electrode 130 may have various modified structures so as to increase the capacitance.

The interface structure 140 may be interposed between the primary lower electrode 130 and the primary dielectric layer 142. The interface structure 140 may have a structure in which a first interface layer 134a, a second interface layer 134b, and a third interface layer 136a are sequentially stacked on the surface of the primary lower electrode 130.

The first interface layer 134a may include or may be a second metal oxide doped with a pentavalent element. A pentavalent element may be an element with five valence electrons. In example embodiments, the first interface layer 134a may include an electrode oxide. The term "electrode oxide" refers to a metal oxide layer having electrical conductivity. A component "having electrical conductivity" refers to an electrical conductor (e.g. as compared to an electrical insulator or dielectric material). This may be a material that conducts electricity at room temperature (e.g. 20°C) and standard atmospheric pressure (e.g. latm (1.013 × 10⁵ Pa)). In example embodiments, the first interface layer 134a may include a metal material the same as the metal material included in the primary lower electrode 130. In example embodiments, the pentavalent element may be, e.g., vanadium (V), niobium (Nb), tantalum (Ta), antimony (Sb), phosphorus (P), etc. For example, when the primary lower electrode 130 includes titanium nitride, the first interface layer 134a may include titanium oxide doped with at least one of the pentavalent elements.

If the first interface layer is not doped with the pentavalent element, the first interface layer may have a low conductivity or even no conductivity (e.g. may be an insulator). Therefore, the capacitance of the capacitor may be decreased by the poor electrical conductivity of the first interface layer. As the pentavalent element is doped into the first interface layer 134a, an electrical conductivity of the first interface layer 134a may increase. Therefore, a decrease of the capacitance of the capacitor due to the first interface layer 134a may be prevented. However, in some example embodiments, the first interface layer may not be doped with the pentavalent element to simplify manufacturing processes.

The second interface layer 134b may be a material further doped with nitrogen in the material (i.e. the second metal oxide) of the first interface layer 134a. The second interface layer 134b may include or be the second metal oxide doped with the pentavalent element and nitrogen.

In example embodiments, the second interface layer 134b may include titanium oxide doped with the pentavalent element and nitrogen. That is, a nitrogen concentration of the first interface layer 134a may be lower than a nitrogen concentration of the second interface layer 134b. In example embodiments, the second interface layer 134b may have electrical conductivity. Accordingly, the first and second interface layers 134a and 134b may function as electrode materials (in combination with the primary lower electrode) of the capacitor.

The first and second interface layers 134a and 134b may be disposed only on the surface of the primary lower electrode 130. In example embodiments, the first interface layer 134a may cover a sidewall and an upper surface of the primary lower electrode 130, and the second interface layer 134b may cover the first interface layer 134a. Therefore, the first and second interface layers 134a and 134b may not be formed along the etch stop layer 106 between an adjacent pair of the primary lower electrodes 130. The first interface layer 134a may contact the surface of the primary lower electrode 130.

In example embodiments, the first interface layer 134a may have a thickness of about 5Å to about 10Å (e.g. a thickness falling in the range of 5Å to 10Å), and the second interface layer 134b may have a thickness of about 5Å to about 10Å (e.g. a thickness falling in the range of 5Å to 10Å). Since the first and second interface layers 134a and 134b include metal oxide formed by oxidation of the surface of the primary lower electrode 130, it is difficult to form each of the first and second interface layers 134a and 134b having a thickness less than about 5 Å. Additionally, when each of the first and second interface layers 134a and 134b are formed to have a thickness greater than about 10 Å, the capacitor having the first and second interface layers 134a and 134b may not be suitable for high integration.

The third interface layer 136a may include or be a third metal oxide doped with nitrogen (i.e., nitrogen- doped metal oxide). The metal included in the third metal oxide may be a tetravalent metal (i.e., a metal with an outermost electron number of 4). The third metal oxide may include an oxide of a tetravalent metal. The third metal oxide may be a high-k dielectric material (e.g. a material having a dielectric constant higher than a dielectric constant of silicon nitride). The third interface layer 136a may function as portion of the dielectric material of the capacitor. The third interface layer 136a may be continuously formed on an upper surface of the second interface layer 134b and an area between the adjacent pair of the primary lower electrodes 130. The third interface layer 136a may cover the upper surface of the second interface layer 134b and the etch stop layer 106.

In example embodiments, the third interface layer 136a may include or be formed of nitrogen-doped hafnium oxide or nitrogen-doped zirconium oxide. In some example embodiments, the third interface layer 136a may include or be formed of nitrogen-doped aluminum oxide.

In example embodiments, a nitrogen concentration of the third interface layer 136a may be less than 10% (atomic percent). When the nitrogen concentration of the third interface layer 136a is greater than about 10%, physical properties of the third interface layer 136a may change and the electrical conductivity of the third interface layer 136a may increase. Therefore, the leakage currents of the capacitor may increase undesirably. Meanwhile, for reducing the leakage currents, the nitrogen concentration of the third interface layer 136a may preferably be greater than about 1%. Accordingly, the nitrogen concentration of the third interface layer 136a may be about 1% to about 10% (e.g. the nitrogen concentration of the third interface layer 136a may fall within the range of 1% to 10%).

In example embodiments, the nitrogen concentration of the second interface layer 134b may be higher than the nitrogen concentration of the third interface layer 136a. Accordingly, the nitrogen concentration in the interface structure 140 may gradually increase and then gradually decrease in a direction from a top surface of the primary lower electrode 130 toward the primary dielectric layer 142.

In example embodiments, the third interface layer 136a may have a thickness of about 5Å to about 15Å (e.g. a thickness of falling within the range of 5Å to 15Å). When the thickness of the third interface layer 136a is less than about 5Å, the leakage currents may be unfavorably high. When the thickness of the third interface layer 136a is greater than about 15Å, the capacitance of the capacitor may be unfavorably decreased due to the thick dielectric material.

The primary dielectric layer 142 may contact an upper surface of the third interface layer 136a. The primary dielectric layer 142 may cover the upper surface of the third interface layer 136a. The primary dielectric layer 142 may include or be a first metal oxide. The first metal oxide may include a tetravalent metal therein. The primary dielectric layer 142 may have a dielectric constant higher than a dielectric constant of silicon nitride.

In example embodiments, the primary dielectric layer 142 may include or be formed of hafnium oxide and/or zirconium oxide. In some example embodiments, the primary dielectric layer 142 may further include aluminum oxide. Hafnium oxide, zirconium oxide and aluminum oxide may be used alone, or may be used as a stack of two or more layers. Alternatively, the primary dielectric layer 142 may be a composite material including two or more of hafnium oxide, zirconium oxide, and aluminum oxide.

In example embodiments, the primary dielectric layer 142 contacting the upper surface of the third interface layer 136a may include a metal material the same as the metal material included in the third interface layer 136a.

A thickness of the primary dielectric layer 142 may be greater than the thickness of the interface structure 140. In example embodiments, the thickness of the primary dielectric layer 142 may be about 25Å to about 55Å (e.g. the thickness may fall within the range of be 25Å to 55Å).

The thickness of a layer generally refers to the dimension of a layer in the direction perpendicular to the surface on which it is deposited, unless the context clearly indicates otherwise. It should be understood that the orientation of a surface refers to its general / average orientation and would not include minor deviations (pits or bumps) that may be formed therein, and which would technically alter the orientation of a surface, for example, at an atomic level.

When the surface on which the layer is deposited changes directions (e.g., the layer is deposited on horizontal and vertical portions of a surface), it should be appreciated that the thickness of a layer may extend in different directions. However, generally, the thickness of a layer should not be considered to reflect the dimension of a layer extending along a first surface in a direction parallel (or oblique) to the first surface even though it may be a direction perpendicular to a second surface of that layer. For example, in Fig. 1, the thickness of primary dielectric layer 142 for a portion extending along the sidewalls of third interface layer 136a would be represented by the horizontal dimension of primary dielectric layer 142 midway of the height of primary lower electrode 130, but not at a location at the base of primary lower electrode 130. For example, the horizontal dimension of primary dielectric layer 142 just above, and parallel to, the horizontal surface of third interface layer 136a would not be considered a thickness of primary dielectric layer 142 even though it may be perpendicular to third interface layer 136a at the base of primary lower electrode 130, where third interface layer 136a extends vertically.

The primary dielectric layer 142 and the third interface layer 136a may function as a dielectric material of the capacitor. A sum of thicknesses of the primary dielectric layer 142 and the third interface layer 136a may be about 40Å to about 60Å (e.g. may fall within the range of 40Å to 60Å). When the sum of the thicknesses of the primary dielectric layer 142 and the third interface layer 136a is less than about 40Å, the leakage currents of the capacitor may be unfavorably high. When the sum of the thicknesses of the primary dielectric layer 142 and the third interface layer 136a is greater than about 60Å, the capacitance of the capacitor may be unfavorably low.

The upper electrode 150 may be formed on the primary dielectric layer 142.

The upper electrode 150 may include or be formed of metal nitride. In example embodiments, the upper electrode 150 may include or be formed of titanium nitride (TiN), titanium (Ti), titanium silicon nitride (TiSiN), tantalum (Ta), tantalum nitride (TaN), or tantalum silicon nitride (TaSiN). For example, the upper electrode 150 may be titanium nitride.

The upper electrode 150 may include the material the same as the material of the primary lower electrode 130. Alternatively, the upper electrode 150 may include the material different from the material of the primary lower electrode 130.

A plate electrode may be further disposed on the upper electrode 150. For example, the plate electrode may include or be formed of silicon-germanium doped with impurities.

In general, oxygen included in the primary dielectric layer 142 may escape downward from an interface area contacting a bottom of the primary dielectric layer 142 of the capacitor, if the capacitor does not include the interface structure 140. Therefore, oxygen vacancies may be significantly increased at the interface area contacting a bottom of the primary dielectric layer 142 of the capacitor. When a concentration of the oxygen vacancies increases, trap sites caused by the oxygen vacancies may increase. Due to tunneling of charges through the increased trap sites, the leakage currents of the capacitor may be undesirably high.

According to example embodiments, the interface structure 140 may be between the primary dielectric layer 142 and the primary lower electrode 130, and the third interface layer 136a may contact the bottom surface of the primary dielectric layer 142.

Since the first and second interface layers 134a and 134b include the conductive metal oxide, an effective thickness dielectric of the capacitor may not be increased due to the first and second interface layers 134a and 134b. The third interface layer 136a may include nitrogen, and the nitrogen may combine with the trap sites between the primary dielectric layer 142 and the third interface layer 136a. Therefore, the trap sites at the interface area contacting the bottom of the primary dielectric layer 142 may be decreased. Accordingly, the leakage currents of the capacitor generated by the trap sites may be decreased. The nitrogen included in the third interface layer 136a may be less than 10%, so that the leakage currents due to changes of the physical properties of the third interface layer 136a may not be significantly high. Accordingly, the capacitance of the capacitor may not be decreased by the interface structure 140. There may be some concentration of nitrogen in the primary dielectric layer 142, or may be no nitrogen, but in either case the nitrogen concentration of the third interface layer 136a is higher than a nitrogen concentration of the primary dielectric layer 142.

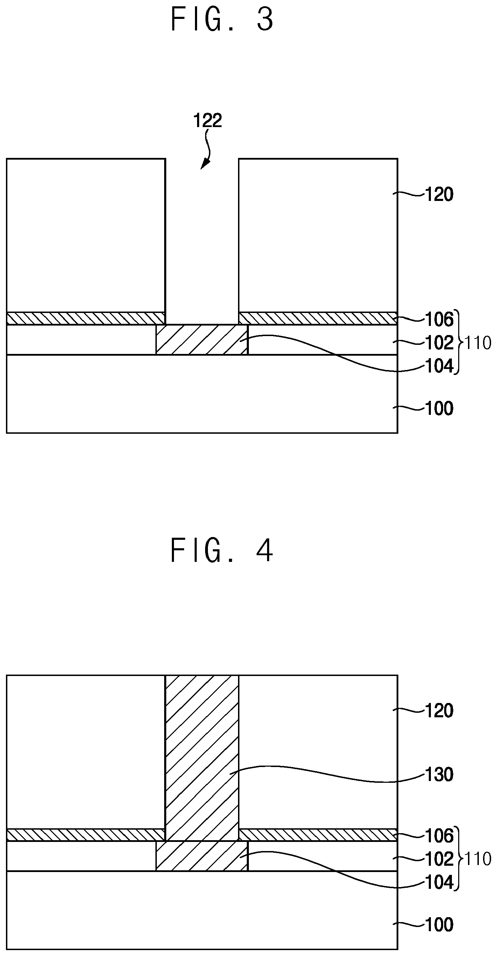

FIGS. 3 to 11 are cross-sectional views for illustrating a method of forming a capacitor according to example embodiments.

Referring to FIG. 3, a lower structure 110 may be formed on a substrate 100.

The lower structure 110 may include a transistor, a contact plug, a conductive pattern 104, a conductive line, an insulating interlayer 102, and an etch stop layer 106.

A mold layer 120 may be formed on the lower structure 110. Portions of the mold layer 120 and the etch stop layer 106 may be etched to form a hole 122 for forming a primary lower electrode of the capacitor. Although only one hole is shown in FIG. 3, the number of holes may not be limited thereto. A plurality of holes may be repeatedly arranged on the lower structure 110. An upper surface of the conductive pattern 104 may be exposed by a bottom of the hole 122.

Referring to FIG. 4, a primary lower electrode layer may be formed on the mold layer 120 to fill the hole 122. The primary lower electrode layer may be planarized until an upper surface of the mold layer 120 is exposed to form a primary lower electrode 130 in the hole 122.

In example embodiments, the primary lower electrode layer may be deposited by a deposition process such as a chemical vapor deposition (CVD) or atomic layer deposition (ALD) process. Additionally, the planarization process may include a chemical mechanical polishing process and/or an etch-back process.

In some example embodiments, a primary lower electrode layer may be formed on the lower structure 110, and the primary lower electrode layer may be patterned by a photolithography process to form the primary lower electrode 130. In this case, the mold layer 120 may not be formed.

The primary lower electrode layer may include metal or metal nitride. In example embodiments, the primary lower electrode layer may include or be formed of titanium nitride (TiN), titanium (Ti), titanium silicon nitride (TiSiN), tantalum (Ta), tantalum nitride (TaN), or tantalum silicon nitride (TaSiN).

In example embodiments, the primary lower electrode layer may be formed by a deposition process using a metal source gas such as a titanium source gas and a nitrogen source gas such as ammonia. Accordingly, the primary lower electrode layer may include, e.g., a metal nitride such as titanium nitride.

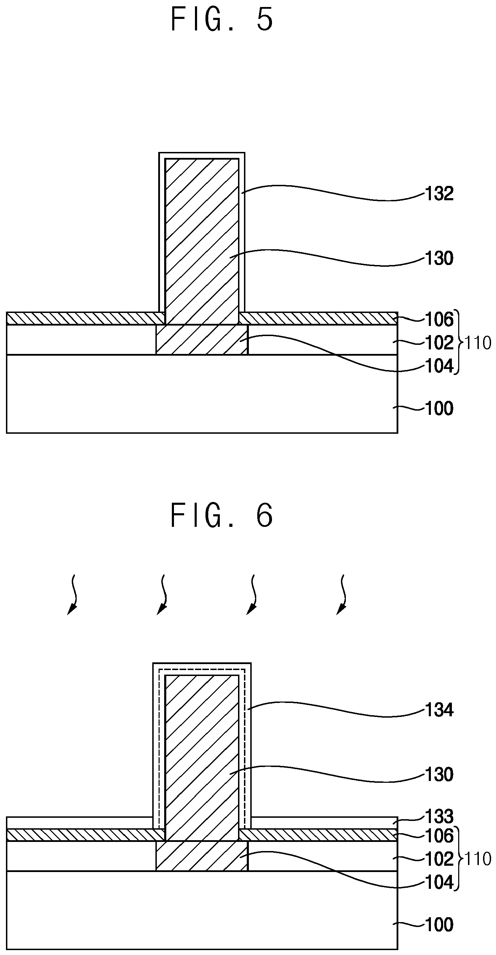

Referring to FIG. 5, the mold layer 120 may be removed. Accordingly, a sidewall and upper surface of the primary lower electrode 130 having a pillar shape may be exposed.

In example embodiments, the mold layer 120 may be removed by a wet etching process.

In this case, a preliminary metal oxide layer 132 may be formed on an exposed surface of the primary lower electrode 130 by oxidation (e.g. a natural oxidation). For example, when the primary lower electrode 130 is formed of titanium nitride, the preliminary metal oxide layer 132 formed on the exposed surface of the primary lower electrode 130 may be titanium oxide. The preliminary metal oxide layer 132 may include nitrogen, because the preliminary metal oxide layer 132 is formed by the natural oxidation of preliminary metal oxide layer 132 which includes nitrogen. Accordingly, the preliminary metal oxide layer 132 may be "titanium oxynitride" instead of "titanium oxide". It should be appreciated that the term "metal oxide" as discussed herein, may refer to a material comprising metal and oxygen (in various ratios), and it may further include another element like nitrogen.

A reaction layer may be formed on the lower structure 110 and the sidewall and upper surface of the primary lower electrode 130.

The reaction layer may be conformally formed on upper surfaces of the preliminary metal oxide layer 132 and the etch stop layer 106.

The reaction layer may be a material layer including a pentavalent element. The reaction layer may include, e.g., vanadium oxide, vanadium nitride, niobium oxide, niobium nitride, or tantalum oxide.

The reaction layer may be formed by an atomic layer deposition process.

In example embodiments, a deposition process using a first reaction gas and a second reaction gas may be performed to form the reaction layer. The first reaction gas may be a source gas including the pentavalent element. The second reaction gas may include, e.g., an oxygen source gas such as ozone (O₃) or a nitrogen source gas such as N₂.

Referring to FIG. 6, after the reaction layer is conformally formed, a heat treatment process may be performed on the reaction layer to diffuse downward (e.g. into the preliminary metal oxide layer 132) the pentavalent element included in the reaction layer, (i.e., a doping process to introduce dopants of the pentavalent element into the preliminary metal oxide layer 132)

When the heat treatment process is performed, the pentavalent element included in the reaction layer may be doped into the preliminary metal oxide layer 132. Therefore, the reaction layer and the preliminary metal oxide layer 132 may be merged to form a first preliminary interface layer 134. For reference, the dotted line indicates a position of the upper surfaces of the preliminary metal oxide layer 132 before the heat treatment process. Therefore, the first preliminary interface layer 134 may be formed on the sidewall and upper surface of the primary lower electrode 130. The first preliminary interface layer 134 may include an oxide of a metal material included in the primary lower electrode 130, and further doped with the pentavalent element.

In example embodiments, when the primary lower electrode 130 includes titanium nitride, the first preliminary interface layer 134 may include titanium oxide doped with the pentavalent element. The pentavalent element may include, e.g., V, Nb, Ta, Sb, P, etc.

Since the pentavalent element included in the reaction layer hardly diffuses into an inner portion of the etch stop layer 106, the first preliminary interface layer 134 may not be formed on the etch stop layer 106. The reaction layer may remain on the etch stop layer 106 to form a reaction pattern 133.

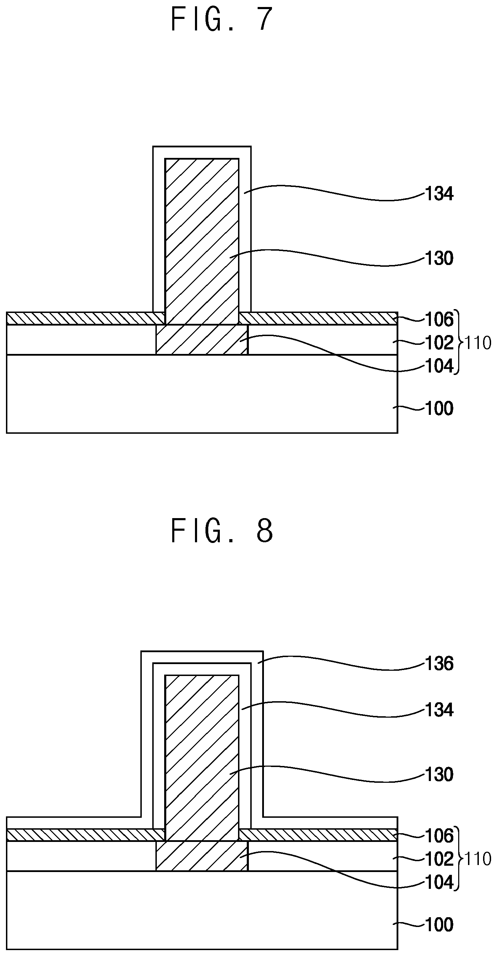

Referring to FIG. 7, the reaction pattern 133 on the etch stop layer 106 may be selectively removed. The removing process may include isotropic etching process such as a wet etching process and/or a wet cleaning process. Accordingly, the first preliminary interface layer 134 may be formed (e.g., conformally formed) only on the sidewall and upper surface of the primary lower electrode 130. The first preliminary interface layer 134 may contact the sidewall and upper surface of the primary lower electrode 130.

When a plurality of primary lower electrodes 130 are formed and the reactive pattern remains between the primary lower electrodes 130, the plurality of primary lower electrodes may be unfavorably electrically connected to each other by the reactive pattern. Therefore, the reaction pattern 133 may be sufficiently removed.

As the first preliminary interface layer 134 is doped with the pentavalent element, a decreasing of the capacitance of the capacitor may be prevented.

In some example embodiments, processes for forming the reaction layer, the heat treatment, and removing the reaction layer may not be performed to simplify the processes. In this case, the first preliminary interface layer may be provided as a metal oxide that is not doped with the pentavalent element.

Referring to FIG. 8, a second preliminary interface layer 136 may be formed (e.g., conformally formed) on the first preliminary interface layer 134 and the etch stop layer 106.

The second preliminary interface layer 136 may include a third metal oxide. The metal included in the third metal oxide of the second preliminary interface layer 136 may include a tetravalent metal. The third metal oxide may include or be a high dielectric constant (high-k) material. A high dielectric constant material may be a material having a dielectric constant higher than a dielectric constant of silicon nitride.

In example embodiments, the second preliminary interface layer 136 may include or be formed of hafnium oxide or zirconium oxide. In some example embodiments, the second preliminary interface layer 136 may include or be formed of aluminum oxide. In example embodiments, the second preliminary interface layer 136 may include the same metal oxide as the metal oxide included in the primary dielectric layer formed by subsequent processes. In example embodiments, the second preliminary interface layer 136 may be formed to have a thickness less than 15 Å.

In example embodiments, the second preliminary interface layer 136 may be formed by an atomic layer deposition process.

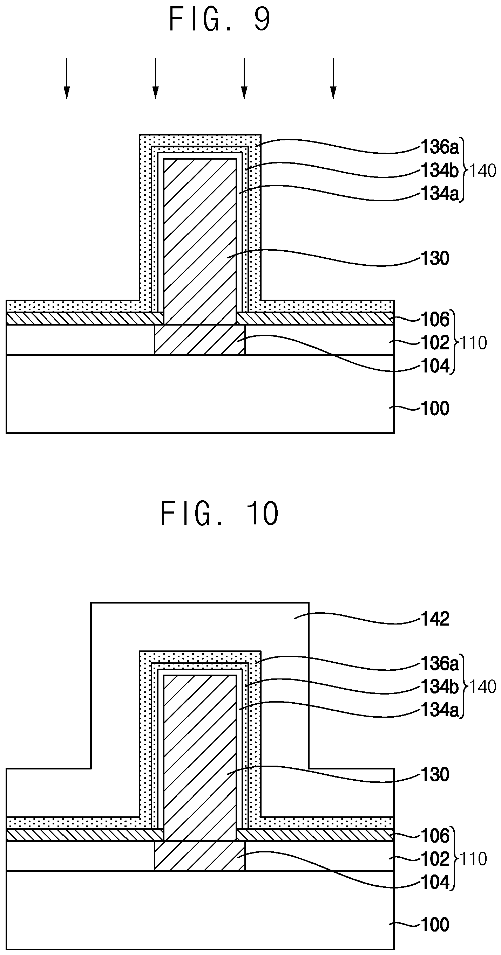

Referring to FIG. 9, a heat treatment or plasma treatment process may be performed on the second preliminary interface layer 136 while introducing a nitrogen source gas, such as nitrogen (N₂) or ammonia (NH₃).

Accordingly, the nitrogen may diffuse into the second preliminary interface layer 136, so that the second preliminary interface layer may be converted into a third interface layer 136a doped with nitrogen. In addition, the nitrogen may diffuse into an upper portion of the first preliminary interface layer 134, so that the upper portion of the first preliminary interface layer 134 may be converted into a second interface layer 134b doped with nitrogen. However, the nitrogen may not diffuse into a lower portion of the first preliminary interface layer 134, so that the lower portion of the first preliminary interface layer 134 may be converted into a first interface layer 134a having a nitrogen concentration lower than that of the second interface layer 134b or no nitrogen.

The first and second interface layers may form a monolithic layer which is formed by a particular process (i.e., the natural oxidation as described above), though the nitrogen concentration of first and second interface layers are different from each other. It should be appreciated that the term "monolithic layer" as discussed herein, may refer to a layer which is formed so as not to have any substantial discontinuous boundary. The discontinuous boundary refers to a boundary, for example, induced by two or more different material formation processes. It should be appreciated that the term "monolithic layer" as discussed herein, may refer to a layer which has two or more portions having different concentration of dopants or impurities. In this sense, the first and second interface layers form a monolithic layer, because there is no substantial boundary which is formed by two or more different processes in their initial deposition. The difference in the nitrogen concentration of the first and second interface layers does not induce the substantial discontinuous boundary.

Accordingly, an interface structure 140 in which the first interface layer 134a, the second interface layer 134b, and the third interface layer 136a are stacked may be formed on the surface of the primary lower electrode 130.

The first interface layer 134a may include a second metal oxide doped with the pentavalent element. The second interface layer 134b may include the second metal oxide further doped with nitrogen. Accordingly, the nitrogen concentration of the second interface layer 134b may be higher than the nitrogen concentration of the first interface layer 134a. The first and second interface layers 134a and 134b are formed only on the sidewall and upper surface of the primary lower electrode 130, and may not be formed on the etch stop layer 106.

The third interface layer 136a may include a third metal oxide doped with nitrogen. In example embodiments, the metal included in the third interface layer 136a may include the tetravalent metal. Since nitrogen included in the third interface layer 136a may move toward an upper electrode formed by subsequent processes, the nitrogen concentration included in the third interface layer 136a may be further decreased by performing the subsequent processes in the later steps of the manufacturing process. After performing the subsequent processes, there may be some concentration of nitrogen in a primary dielectric layer 142, or may be no nitrogen, but in either case the nitrogen concentration of the third interface layer 136a is higher than a nitrogen concentration of the primary dielectric layer 142. Accordingly, the nitrogen concentration included in the second interface layer 134b may be greater than the nitrogen concentration included in the third interface layer 136a. The nitrogen concentration included in the third interface layer 136a may be less than about 10% (atomic percent).

Referring to FIG. 10, the primary dielectric layer 142 may be formed on the third interface layer 136a. The primary dielectric layer 142 may include or be formed of metal oxide. The metal included in the primary dielectric layer 142 may include a tetravalent metal.

In example embodiments, the primary dielectric layer 142 may include a high-k dielectric material having a dielectric constant higher than a dielectric constant of silicon nitride. In example embodiments, the primary dielectric layer 142 may include or be formed of hafnium oxide and/or zirconium oxide. In some example embodiments, the primary dielectric layer 142 may further include or be formed of aluminum oxide. The primary dielectric layer 142 may include a single layer or a stack of two or more layers. Alternatively, the primary dielectric layer 142 may be a composite material layer including two or more of hafnium oxide, zirconium oxide, and aluminum oxide.

A thickness of the primary dielectric layer 142 may be greater than a thickness of the interface structure 140. In example embodiments, the thickness of the primary dielectric layer 142 may be about 25Å to about 55Å (e.g. may fall within the range of 25Å to 55Å). In example embodiments, a sum of the thicknesses of the primary dielectric layer 142 and the third interface layer 136a may be about 40Å to about 60Å (e.g. may fall within the range of 40Å to 60Å).

In example embodiments, a portion of the primary dielectric layer 142 contacting the third interface layer 136a may include a material the same as a material of the third interface layer 136a, but may not be doped with nitrogen. In some example embodiments, a portion of the primary dielectric layer 142 contacting the third interface layer 136a may include a material different from a material of the third interface layer 136a, and may not be doped with nitrogen.

In example embodiments, the primary dielectric layer 142 may be formed by an atomic layer deposition process.

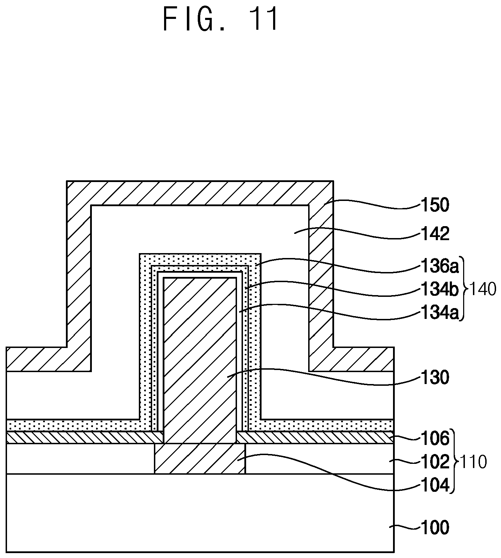

Referring to FIG. 11, an upper electrode 150 may be formed on the primary dielectric layer 142.

In example embodiments, the upper electrode 150 may include or be formed of a material the same as a material of the primary lower electrode 130. Alternately, the upper electrode 150 may include or be formed of a material different from a material of the primary lower electrode 130.

In example embodiments, the upper electrode 150 may be deposited by a chemical vapor deposition (CVD) or atomic layer deposition (ALD) process.

In example embodiments, after forming the upper electrode 150, a heat treatment process may be further performed. Layers included in the primary dielectric layer 142 may be crystallized by the heat treatment process.

For example, the upper electrode 150 may be formed by a deposition process using a metal source gas such as titanium and a nitrogen source gas such as ammonia. Accordingly, the upper electrode 150 may include, e.g., a metal nitride such as titanium nitride.

A plate electrode may be further formed on the upper electrode 150. For example, the plate electrode may include or be formed of silicon-germanium doped with impurities.

Through the above process, a capacitor including the primary lower electrode 130, the interface structure 140, the primary dielectric layer 142, and the upper electrode 150 may be formed. The capacitor may include the interface structure 140, so that leakage currents of the capacitor may be decreased.

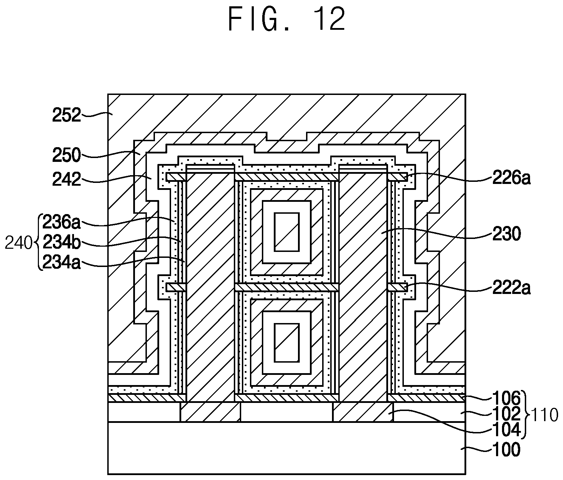

FIG. 12 is a cross-sectional view illustrating capacitors according to example embodiments.

With reference to FIG. 12, a plurality of capacitors regularly arranged may be described. Each of the capacitors shown in FIG. 12 may be the same as the capacitor shown in FIG. 1, except that that each of the capacitors may further include a support layer pattern and a plate electrode. Therefore, repeated explanations may be omitted.

Referring to FIG. 12, the capacitor may include a primary lower electrode 230, a first support layer pattern 222a, a second support layer pattern 226a, an interface structure 240, a primary dielectric layer 242, and an upper electrode 250. In addition, a plate electrode 252 may be formed on the upper electrode 250.

In example embodiments, the capacitor may be disposed on the lower structure 110 formed on the substrate 100. The lower structure 110 may include, e.g., a transistor, a contact plug, a conductive pattern 104, a conductive line, an insulating interlayer 102, and an etch stop layer 106.

The primary lower electrodes 230 may each pass through the etch stop layer 106. Each of the primary lower electrodes 230 may contact a corresponding one of the conductive patterns 104.

In example embodiments, each primary lower electrode 230 may have a pillar shape. Alternatively, the primary lower electrode may have a cylindrical shape (i.e., cup shape).

The plurality of primary lower electrodes 230 may be regularly and repeatedly arranged. In example embodiments, the primary lower electrodes 230 may have a honeycomb arrangement in which the primary lower electrodes 230 are disposed at vertices and center portions of connected hexagons.

The first support layer pattern 222a may have a connected structure while surrounding the sidewall of each of the primary lower electrodes 230. The second support layer pattern 226a may have a connected structure while surrounding the sidewall of each of the primary lower electrodes 230. For example, each of the first and second support layer patterns 222a and 226a may have an upper and lower surface parallel to an upper surface of the substrate 100. The first and second support layer patterns 222a and 226a may be positioned at different vertical levels. The primary lower electrodes 230 may be supported by the first and second support layer patterns 222a and 226a, so that the primary lower electrodes 230 may not unfavorably lean. In FIG. 12, two support layer patterns may be formed on the sidewalls of the primary lower electrodes 230. However, the number of the support layer patterns may not be limited thereto. One support layer pattern or three or more support layer patterns may be formed on the sidewalls of the primary lower electrodes 230.

The first support layer pattern 222a may surround a central sidewall of each primary lower electrode 230, and the second support layer pattern 226a may surround an upper sidewall of each primary lower electrode 230. In a plan view, each of the first and second support layer patterns 222a and 226a may have a mesh shape.

The first and second support layer patterns 222a and 226a may include or be formed of, e.g., an insulating nitride material such as silicon nitride (SiN), boronitride (SiBN), or silicon carbonitride (SiCN).

The interface structure 240 may be interposed between the primary lower electrodes 230 and the primary dielectric layer 242. The interface structure 240 may have a structure in which a first interface layer 234a, a second interface layer 234b, and a third interface layer 236a are sequentially stacked on the primary lower electrodes 230.

The first and second interface layers 234a and 234b may be sequentially formed on the sidewalls and upper surfaces of the primary lower electrodes 230. The first and second interface layers 234a and 234b may not be formed along surfaces of the first and second support layer patterns 222a and 226a or along a surface of the etch stop layer 106. The first interface layer 234a may contact the sidewall and upper surface of each primary lower electrode 230.

The third interface layer 236a may be conformally formed on an upper surface of the second interface layer 234b and surfaces of the etch stop layer 106, the first support layer pattern 222a and the second support layer pattern 226a.

The primary dielectric layer 242 may be disposed on the interface structure 240. An upper electrode 250 may cover the primary dielectric layer 242. The upper electrode 250 may be continuously formed on the surface of the primary dielectric layer 242. The upper electrode 250 may not completely fill a space between the primary lower electrodes 230.

A plate electrode 252 may be disposed on the upper electrode 250 to completely fill the space between the primary lower electrodes 230. The upper surface of the plate electrode 252 may be higher than an uppermost surface of each primary lower electrode 230. For example, the plate electrode 252 may include or be formed of silicon-germanium doped with impurities.

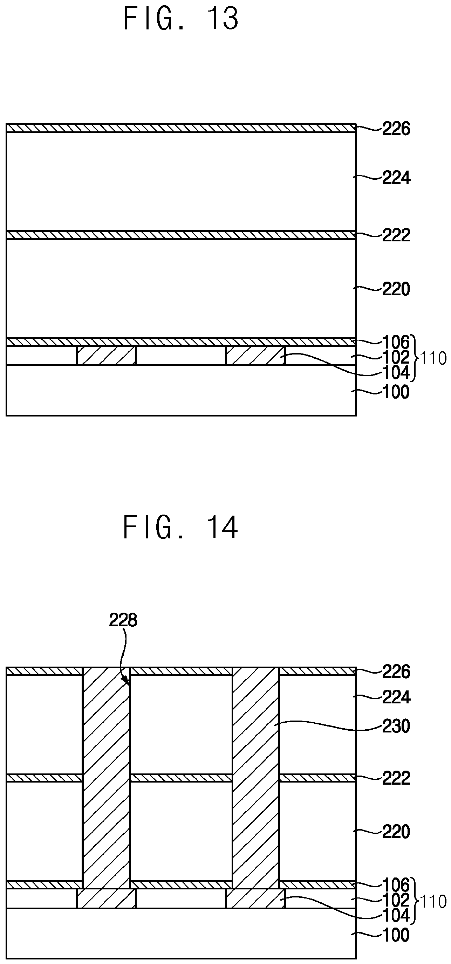

FIGS. 13 to 18 are cross-sectional views illustrating a method of forming a capacitor according to example embodiments.

Referring to FIG. 13, a lower structure 110 may be formed on a substrate 100.

The lower structure 110 may include a transistor, a contact plug, a conductive pattern 104, a conductive line, an insulating interlayer 102, and an etch stop layer 106.

Mold layers 220 and 224 and support layers 222 and 226 are alternately formed on the lower structure 110. In example embodiments, a first mold layer 220, a first support layer 222, a second mold layer 224, and a second support layer 226 may be formed on the lower structure 110. Hereinafter, two support layers and two mold layers formed on the lower structure 110 may be described, but the number of the support layers and the mold layers may not be limited thereto. One or three or more support layers and mold layers may be formed on the lower structure 110.

Referring to FIG. 14, the second support layer 226, the second mold layer 224, the first support layer 222, the first mold layer 220, and the etch stop layer 106 may be etched to form holes 228 for forming a primary lower electrode of a capacitor. An upper surface of the conductive pattern 104 may be exposed by a bottom of the hole 228.

A primary lower electrode layer may be formed on the second support layer 226 to fill the holes 228. The primary lower electrode layer may be planarized until an upper surface of the second support layer 226 is exposed to form a primary lower electrode 230 in each of the holes 228. The process for forming the primary lower electrodes 230 may be the same as that described with reference to FIG. 4.

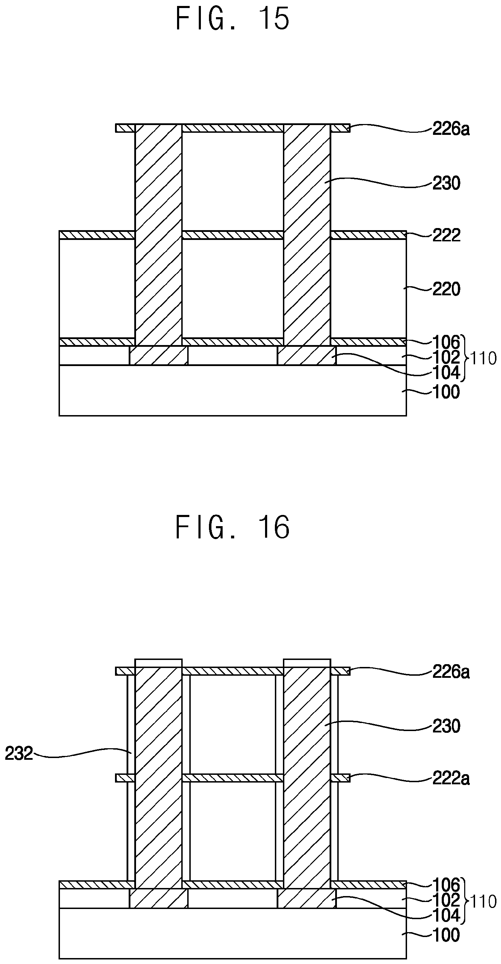

Referring to FIG. 15, a portion of the second support layer 226 may be etched to form a second support layer pattern 226a. Thereafter, the second mold layer 224 exposed between the second support layer patterns 226a may be removed. The removing process may include a wet etching process. When the second mold layer 224 is removed, the first support layer 222 and an upper portion of each of the primary lower electrodes 230 may be exposed.

Referring to FIG. 16, a portion of the first support layer 222 may be etched to form a first support layer pattern 222a. Thereafter, the first mold layer 220 exposed between the first support layer patterns 222a may be removed. The removing process may include a wet etching process. Accordingly, surfaces of the primary lower electrodes 230 may be exposed. The surfaces of the primary lower electrodes 230 may be naturally oxidized, so that a preliminary metal oxide layer 232 may be formed on the exposed surface of the primary lower electrodes 230.

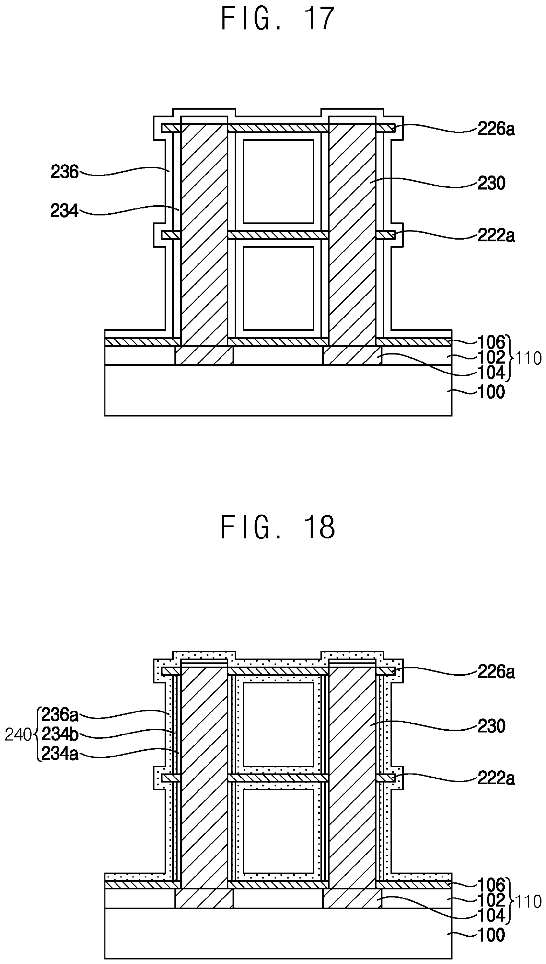

Referring to FIG. 17, a reaction layer may be conformally formed on the sidewall and upper surface of each primary lower electrode 230 and the surfaces of the etch stop layer 106, the first support layer patterns 222a and the second support layer pattern 226a. Thereafter, a heat treatment process may be performed on the reaction layer. Accordingly, the first preliminary interface layer 234 may be selectively formed on the sidewall and upper surface of each primary lower electrode 230. Additionally, the reaction layer remaining on the surface of the etch stop layer 106 and the first and second support layer patterns 222a and 226a may be removed. Accordingly, the first preliminary interface layer 234 may not be formed along the surfaces of the etch stop layer 106, the first support layer pattern 222a and second support layer pattern 226a.

Subsequently, a second preliminary interface layer 236 may be formed on the first preliminary interface layer 234.

The processes for forming the first and second preliminary interface layers 234 and 236 may be substantially the same as those described with reference to FIGS. 6 to 8.

Referring to FIG. 18, a heat treatment or plasma treatment process may be performed on the second preliminary interface layer 236 while introducing a nitrogen source gas, such as nitrogen (N₂) or ammonia (NH₃). Accordingly, an interface structure 240, in which a first interface layer 234a, a second interface layer 234b, and a third interface layer 236a are stacked, may be formed on the surface of the primary lower electrodes 230.

In the interface structure 240, the first and second interface layers 234a and 234b may be selectively formed only on the sidewall and upper surface of each primary lower electrode 230. The third interface layer 236a may be formed on the surfaces of the second interface layer 234b, the etch stop layer 106, and the first and second support layer patterns 222a and 226a.

Thereafter, a primary dielectric layer 242 and an upper electrode 250 may be formed on the interface structure 240. The upper electrode 250 may be continuously formed on the primary dielectric layer 242, and the upper electrode 250 may not completely fill a space between the primary lower electrodes 230.

The processes for forming the interface structure 240, the primary dielectric layer 242, and the upper electrode 250 may be the same as those described with reference to FIGS. 9 to 11.

Referring to FIG. 12 again, a plate electrode 252 may be formed on the upper electrode 250 to completely fill the space between the primary lower electrodes 230. An upper surface of the plate electrode 252 may be higher than an uppermost surface of the primary lower electrode 230. For example, the plate electrode 252 may include silicon-germanium doped with impurities. The plate electrode 252 may be formed by a chemical vapor deposition process or an atomic layer deposition process.

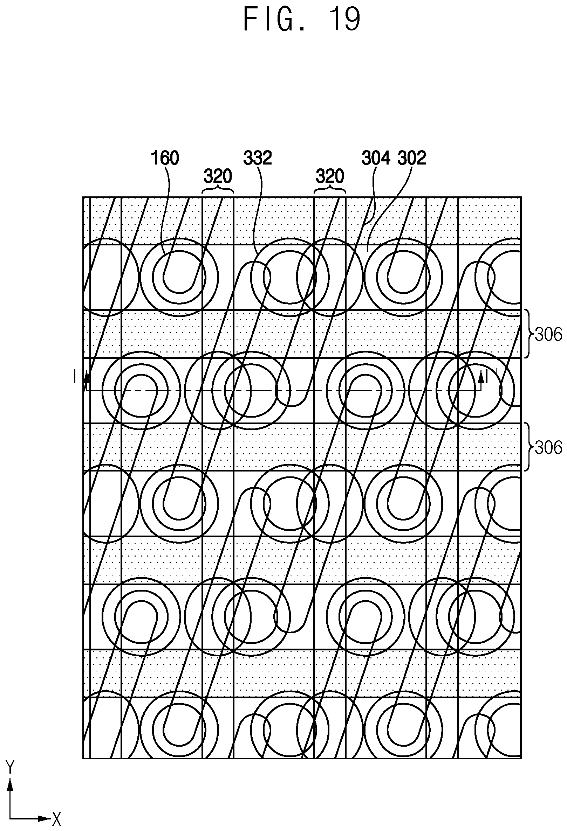

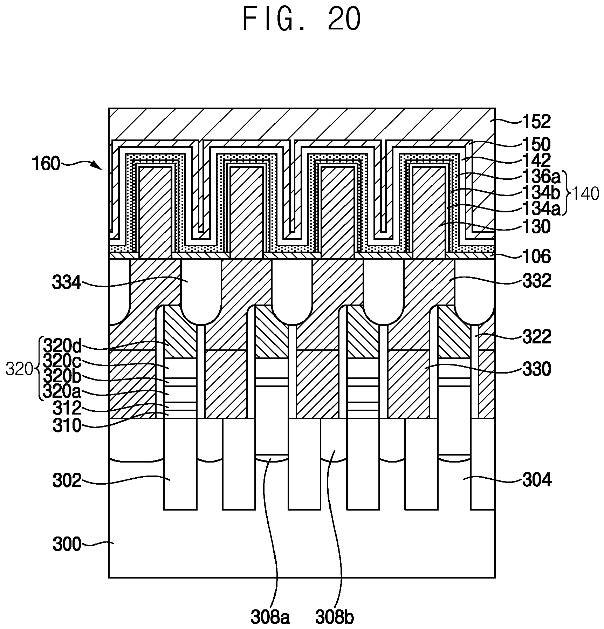

FIG. 19 is a plan view illustrating a layout of a semiconductor device according to example embodiments. FIG. 20 is a cross-sectional view of a semiconductor device according to example embodiments.

The semiconductor device of FIGS. 19 and 20 may be Dynamic Random Access Memory (DRAM) device. To avoid drawing complexity, structures disposed above a primary lower electrode of a capacitor may not be shown in FIG. 19. FIG 20 is a cross-sectional view taken along line I-I' of FIG 19.

Referring to FIGS. 19 and 20, a DRAM device may be formed on a substrate 300. The DRAM device may include selection transistors, capacitors, and bit line structures 320. A unit memory cell of the DRAM device may include one selection transistor and one capacitor. The DRAM device may be, for example, a semiconductor memory chip formed on a semiconductor die. The semiconductor memory chip may be part of a semiconductor package. In general, such a DRAM device, semiconductor memory chip, or semiconductor package may be referred to as a semiconductor device.

The substrate 300 may include a device isolation layer 302. An upper portion of the substrate 300 between the device isolation layers 302 may be defined as an active region 304.

The substrate 300 may include a gate trench extending in a first direction X parallel to an upper surface of the substrate 300. A gate structure 306 may be formed in the gate trench.

In example embodiments, the gate structure 306 may include a gate insulation layer, a gate electrode, and a capping insulation pattern. The gate structure 306 may extend in the first direction X. A plurality of gate structures 306 may be arranged in a second direction Y parallel to the surface of the substrate 300 and perpendicular to the first direction X. The first direction X and the second direction Y may define a horizontal plane of the semiconductor device.

First and second impurity regions 308a and 308b serving as source/drain regions may be formed at an upper portion of the active region 304 between the gate structures 306. The gate structure 306 and the first and second impurity regions 308a and 308b may serve as selection transistors.

A first insulation pattern 310 and a second insulation pattern 312 may be stacked on the active region 304, the device isolation layer 302, and the gate structure 306. For example, the first insulation pattern 310 may include an oxide such as silicon oxide, and the second insulation pattern 312 may include a nitride such as silicon nitride.

A recess may be included at a portion of the substrate 300 where the first and second insulation patterns 310 and 312 are not formed. An upper surface of the first impurity region 308a may be exposed by a bottom of the recess.

A bit line structure 320 may be formed on the second insulation pattern 312 and the recess. The bit line structure 320 may include a conductive pattern 320a, a barrier metal pattern 320b, a metal pattern 320c, and a hard mask pattern 320d. For example, the conductive pattern 320a may include polysilicon doped with impurities. The bit line structures 320 may extend in the second direction. A plurality of bit line structures may be arranged in the first direction. In example embodiments, a spacer 322 may be formed on sidewalls of the bit line structure 320. The spacer may be a plurality of spacer layers laterally stacked on the sidewalls of the bit line structure 320.

A first insulating interlayer (not shown) may be formed to fill a space between the bit line structures 320.

A stacked structure including a contact plug 330 and a landing pad 332 may pass through the first insulating interlayer, the second insulation pattern 312 and the first insulation pattern 310, and the stacked structure may contact the second impurity region 308b. The landing pad 332 may be disposed on the contact plug 330. An insulation pattern 334 may be formed between the landing pads 332.

An etch stop layer 106 may be formed on the landing pad 332, the insulation pattern 334, and the first insulating interlayer. A capacitor 160 may pass through the etch stop layer 106, and may contact the landing pad 332.

The etch stop layer 106 may include, e.g., silicon nitride, silicon oxynitride, etc.

The capacitor 160 may include the primary lower electrode 130, the interface structure 140, the primary dielectric layer 142, and the upper electrode 150. A bottom of the primary lower electrode 130 may contact the landing pad 332. A plate electrode 152 may be further formed on the upper electrode 150.

In example embodiments, the capacitor 160 may be substantially the same as the capacitor described with reference to FIG. 1. In some example embodiments, the capacitor may be substantially the same as the capacitor described with reference to FIG. 12.

The capacitor may have high capacitance, and leakage currents of the capacitor may be significantly low.

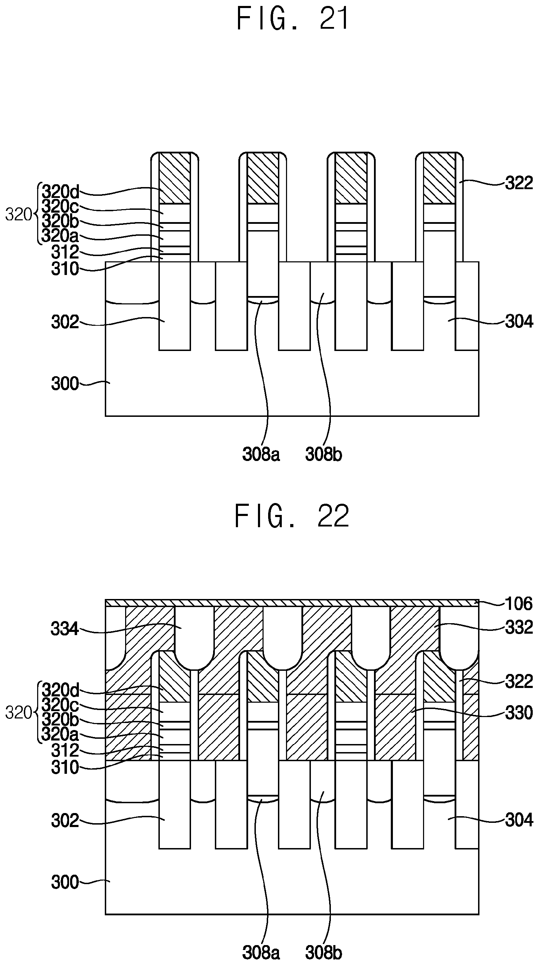

FIGS. 21 and 22 are cross-sectional views illustrating a method for manufacturing a semiconductor device according to example embodiments.

Referring to FIG. 21, a shallow trench isolation (STI) process may be performed on a substrate 300 to form a device isolation layer 302. Accordingly, the substrate 300 may be divided into a device isolation region where the device isolation layer 302 is formed and an active region 304 between the device isolation layers 302.

Upper portions of the substrate 300 and the device isolation layer 302 may be etched to form a gate trench (not shown) extending in the first direction. A gate structure (not shown) may be formed in the gate trench. First and second impurity regions 308a and 308b may be formed at the active region 304 adjacent to both sides of the gate structure.

A first insulation pattern 310 and a second insulation pattern 312 may be formed on the active region 304, the device isolation layer 302, and the gate structure. A recess may be formed at a portion of the substrate on which the first and second insulation patterns 310 and 312 are not formed. An upper surface of the first impurity region 308a may be exposed by a bottom of the recess.

A bit line structure 320 extending in the second direction may be formed on the second insulation pattern 312 and the recess. The bit line structure 320 may have a structure including a conductive pattern 320a, a barrier metal pattern 320b, a metal pattern 320c, and a hard mask pattern 320d stacked. In example embodiments, a spacer 322 may be formed on sidewalls of the bit line structure 320.

Referring to FIG. 22, a first insulating interlayer (not shown) may be formed to cover the bit line structures 320.

A portion of the first insulating interlayer between the bit line structures 320 may be etched to form a contact hole exposing the second impurity region 308b. A contact plug 330 and a landing pad 332 may be formed to fill the contact hole. An insulation pattern 334 may be formed between the landing pads 332.

An etch stop layer 106 may be formed on the first insulating interlayer, the landing pad 332, and the insulation pattern 334.

Referring to FIG. 20 again, processes substantially the same or similar to the processes described with reference to FIGS. 3 to 11 may be performed to form the capacitor 160. The capacitor 160 may include the primary lower electrode 130, the interface structure, the primary dielectric layer 142, and the upper electrode 150. Thereafter, the plate electrode 152 may be formed on the upper electrode 150.

In some example embodiments, processes substantially the same as or similar to the processes described with reference to FIGS. 13 to 18 may be performed to form the capacitor having the structure shown in FIG. 12.

Accordingly, a DRAM device including the capacitor with low leakage currents may be manufactured.

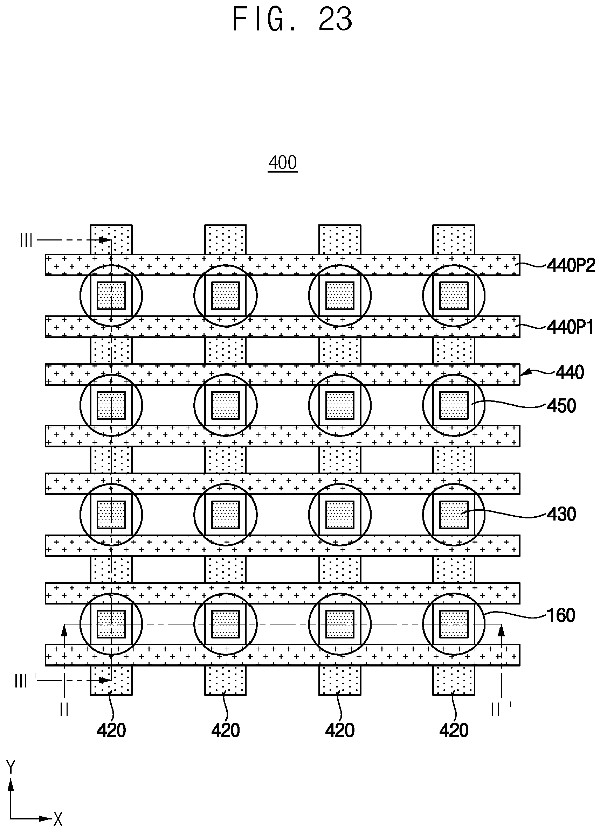

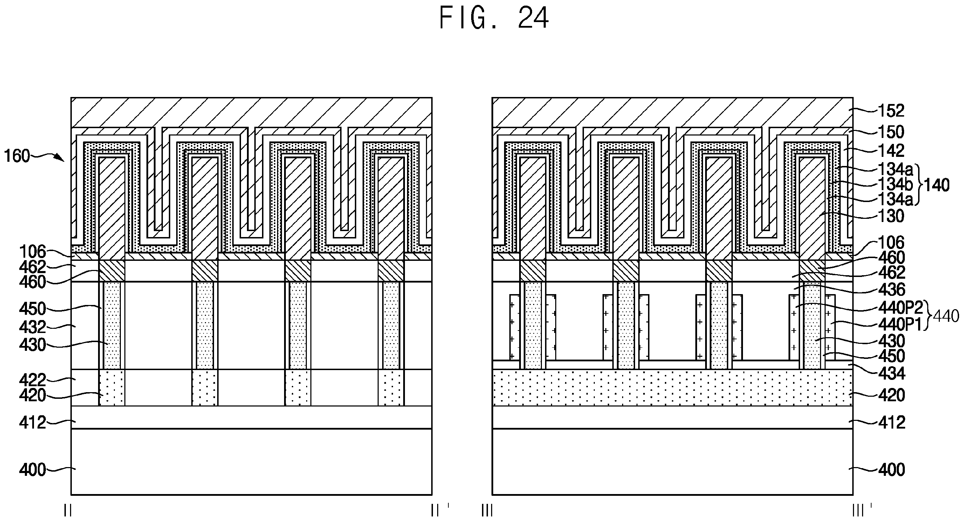

FIG. 23 is a layout illustrating a semiconductor device according to example embodiments. FIG. 24 is cross-sectional views illustrating a semiconductor device according to example embodiments.

FIG. 24 includes cross-sectional views taken along lines each of II-II' and III-III' of FIG. 23. The semiconductor device may be a vertical channel transistor (VCT) DRAM device including the capacitor described with reference to FIGS. 1 and 2, and redundant description of the capacitor will be omitted.

Referring to FIGS. 23 and 24, the DRAM device may include a substrate 400, a plurality of first conductive lines 420, a channel layer 430, a gate electrode 440, a gate insulation layer 450, and the capacitor 160. The DRAM device may include a vertical channel transistor (VCT). The vertical channel transistor may have a structure in which a channel length of the channel layer 430 extends in a vertical direction from an upper surface of the substrate 400.

A lower insulation layer 412 may be disposed on the substrate 400, and the plurality of first conductive lines 420 may be disposed on the lower insulation layer 412 to be spaced apart from each other in the first direction X and in the second direction Y. A plurality of first insulation patterns 422 may be arranged on the lower insulation layer 412 to fill a space between the plurality of first conductive lines 420. The plurality of first insulation patterns 422 may extend in the second direction Y, and upper surfaces of the plurality of first insulation patterns 422 may be coplanar with upper surfaces of the plurality of first conductive lines 420. The plurality of first conductive lines 420 may function as bit lines of the DRAM device.

In example embodiments, the plurality of first conductive lines 420 may include doped polysilicon, metal, conductive metal nitride, conductive metal silicide, conductive metal oxide, or a combination thereof. For example, the plurality of first conductive lines 420 may include doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or a combination thereof, but is not limited thereto. The plurality of first conductive lines 420 may include a single layer or a multilayer of the above-described materials. In some example embodiments, the plurality of first conductive lines 420 may include a two-dimensional semiconductor material, e.g., graphene, carbon nanotube or a combination thereof.

The channel layer 430 may be disposed on the plurality of first conductive lines 420 to be spaced apart in the first direction X and the second direction Y, so that the channel layer 430 may be arranged in a matrix form. The channel layer 430 may have a first width in the first direction X, and a first height in a vertical direction. The vertical direction may be a direction perpendicular to the first direction X and the second direction Y. The first height may be greater than the first width. For example, the first height may be about 2 times to about 10 times the first width, but may be not limited thereto. A lower portion of the channel layer 430 may function as a first source/drain region, an upper portion of the channel layer 430 may function as a second source/drain region. A portion of the channel layer 430 between the first and second source/drain regions may function as a channel region.

In example embodiments, the channel layer 430 may include an oxide semiconductor. The oxide semiconductor may include, e.g., InxGayZnzO, InxGaySizO, InxSnyZnzO, InxZnyO, ZnxO, ZnxSnyO, ZnxOyN, ZrxZnySnzO, SnxO, HfxInyZnzO, GaxZnySnzO, AlxZnySnzO, YbxGayZnzO, InxGayO, or a combination thereof. The channel layer 430 may include a single layer or a multilayer of the oxide semiconductor. In some examples, the channel layer 430 may have a band gap energy greater than a bandgap of silicon. For example, the channel layer 430 may have the band gap energy of about 1.5 eV to about 5.6 eV For example, the channel layer 430 may have optimal channel performance when the channel layer 430 has the band gap energy of about 2.0 eV to about 4.0 eV For example, the channel layer 430 may be polycrystalline or amorphous, but may not be limited thereto. In some example embodiments, the channel layer 430 may include a two-dimensional semiconductor material, e.g., graphene, carbon nanotubes, or a combination thereof.

The gate electrode 440 may extend in the first direction X on both sidewalls of the channel layer 430. The gate electrode 440 may include a first sub-gate electrode 440P1 facing the first sidewall of the channel layer 430, and a second sub-gate electrode 440P2 facing the second sidewall opposite to the first sidewall of the channel layer 430. As one channel layer 430 is disposed between the first sub-gate electrode 440P1 and the second sub-gate electrode 440P2, the DRAM device may have a dual gate transistor structure. However, it may not be limited thereto. For example, the second sub-gate electrode 440P2 may not be formed, and only the first sub-gate electrode 440P1 facing the first sidewall of the channel layer 430 may be formed to form a single gate transistor structure.

The gate electrode 440 may include doped polysilicon, metal, conductive metal nitride, conductive metal silicide, conductive metal oxide, or a combination thereof. The gate electrode 440 may include, e.g., doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or a combination thereof, but may not be limited thereto.

The gate insulation layer 450 may surround a sidewall of the channel layer 430, and may be interposed between the channel layer 430 and the gate electrode 440. For example, as shown in FIG. 23, an entire sidewall of the channel layer 430 may be surrounded by the gate insulation layer 450, and a portion of the sidewall of the gate electrode 440 may contact the gate insulation layer 450. In another example, the gate insulation layer 450 may extend in an extending direction of the gate electrode 440 (e.g., the first direction X), and may be disposed between the gate electrode 440 and the sidewalls of the channel layer 430. The gate insulation layer 450 may contact only the two opposing sidewalls of the channel layer 430.

In example embodiments, the gate insulation layer 450 may include a silicon oxide layer, a silicon oxynitride layer, a high-k dielectric layer having a higher dielectric constant than the silicon oxide layer, or a combination thereof. The high-k dielectric layer may include metal oxide or metal oxynitride. For example, the high-k dielectric layer used as the gate insulation layer 450 may include, e.g., HfO2, HfSiO, HfSiON, HfTaO, HfTiO, HfZrO, ZrO2, Al2O3, or a combination thereof, but may not be limited thereto.

A plurality of second insulation patterns 432 may extend in the second direction Y on the plurality of first insulation patterns 422. The channel layer 430 may be interposed between two adjacent second insulation patterns among the plurality of second insulation patterns 432. A first buried layer 434 and a second buried layer 436 may be disposed in a space between two adjacent channel layers 430. The first buried layer 434 may be disposed on a bottom of the space between the two adjacent channel layers 430. The second buried layer 436 may be disposed on the first buried layer 434 between two adjacent channel layers 430, and may fill a remaining space between the two adjacent channel layers 430. An upper surface of the second buried layer 436 may be coplanar with an upper surface of the surface of the channel layer 430, and the second buried layer 436 may cover an upper surface of the gate electrode 440. In some example embodiments, the plurality of second insulation patterns 432 may include the same material as a material of the plurality of first insulation patterns 422. The plurality of second insulation patterns 432 and the plurality of first insulation patterns 422 may be continuously formed. In some example embodiments, the second buried layer 436 may include the same material as a material of the first buried layer 434. The first and second buried layer 436 may be continuously formed.

A capacitor contact 460 may be disposed on the channel layer 430. The capacitor contact 460 may vertically overlap the channel layer 430, and may be arranged in the matrix form being spaced apart in the first direction X and the second direction Y. The capacitor contact 460 may include, e.g., doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or a combination thereof, but may not be limited thereto. The upper insulation layer 462 may surround a sidewall of the capacitor contact 460 disposed on the plurality of second insulating patterns 432 and the second buried layer 436.

An etch stop layer 106 may be disposed on the upper insulation layer 462, and the capacitor 160 may be pass through the etch stop layer 106, and may contact the capacitor contact 460.

The capacitor 160 may include the primary lower electrode 130, the interface structure 140, the primary dielectric layer 142, and the upper electrode 150. A bottom of the primary lower electrode 130 may contact the capacitor contact 460 serving as a landing pad. The plate electrode 152 may be disposed on the upper electrode 150.

In example embodiments, the capacitor 160 may be substantially the same as the capacitor described with reference to FIG. 1. In some example embodiments, the capacitor may be substantially the same as the capacitor described with reference to FIG. 12.

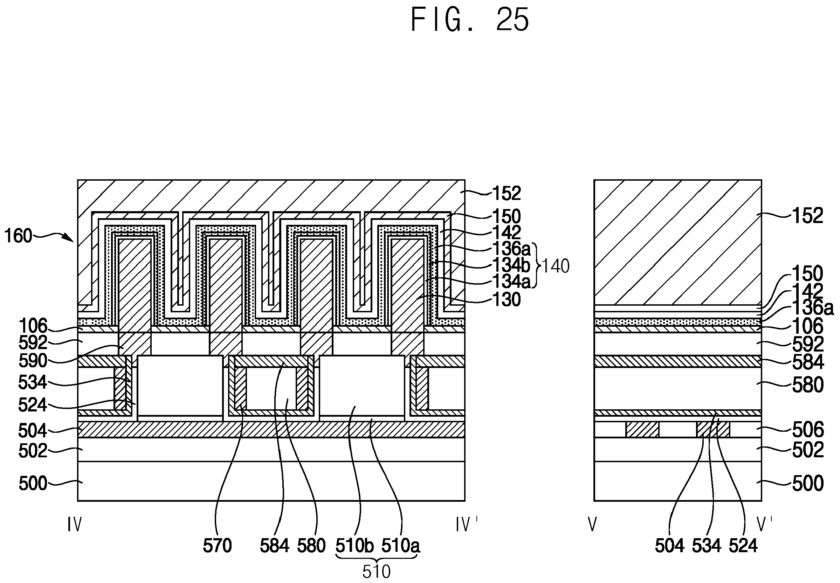

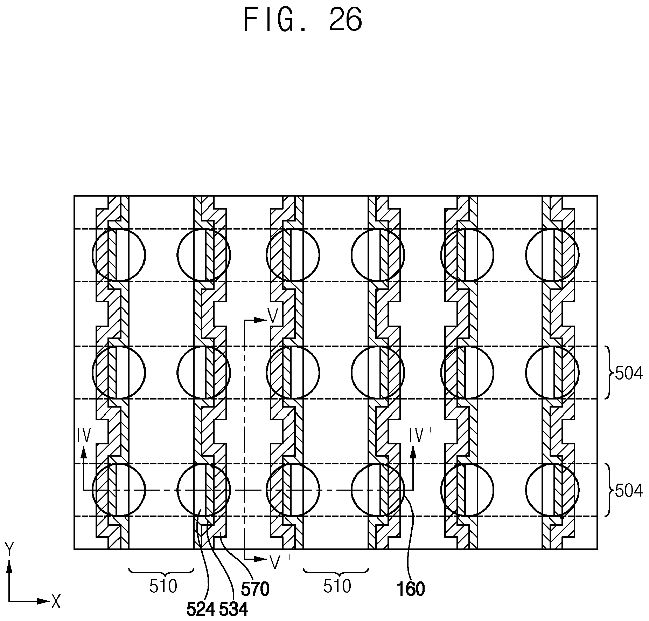

FIG. 25 is a cross-sectional view of a semiconductor device according to example embodiments. FIG. 26 is a plan view illustrating a semiconductor device according to example embodiments.

FIG. 25 includes cross-sectional views taken along lines of IV-IV' and V-V' of FIG. 26.

Referring to FIGS. 25 and 26, the semiconductor device may include a first conductive layer pattern 504, a mold insulation pattern 510, an oxide semiconductor layer pattern 524, a gate insulation layer pattern 534, a second conductive layer patterns 570, a third conductive layer pattern 590, and the capacitor 160 on a substrate 500. The semiconductor device may further include a first lower insulation layer 502, a second lower insulation layer 506, a first insulation layer pattern 580, a second insulation layer pattern 592, a capping layer pattern 584, and the etch stop layer 106. The semiconductor device may include a vertical channel transistor (VCT) formed on the oxide semiconductor layer pattern 524.

The first lower insulation layer 502 may be formed on the substrate 500. The first lower insulation layer 502 may include, e.g., silicon oxide. An upper surface of the first lower insulation layer 502 may be substantially flat. The first lower insulation layer 502 may cover an upper surface of the substrate 500.

The first conductive layer patterns 504 may be disposed on the first lower insulation layer 502, and may have a line shape extending in the first direction X parallel to the upper surface of the substrate 500. The first conductive layer patterns 504 may be spaced apart from each other in the second direction Y parallel to the upper surface of the substrate 500 and perpendicular to the first direction X.

The second lower insulation layer 506 may fill a space between the first conductive layer patterns 504. Upper surfaces of the first conductive layer patterns 504 and the second lower insulation layer 506 may be coplanar with each other, and may be substantially flat. Accordingly, the upper surface of the first conductive layer patterns 504 may be exposed. The first conductive layer pattern 504 may serve as a bit line.

An insulation layer including silicon nitride may be further formed on the first lower insulation layer 502.

In example embodiments, the plurality of first conductive layer patterns 504 may include doped polysilicon, metal, conductive metal nitride, conductive metal silicide, conductive metal oxide, or a combination thereof. The plurality of first conductive layer patterns 504 may include, e.g., doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or a combination thereof, but may not be limited thereto. The plurality of first conductive layer patterns 504 may include a single layer or multiple layers of the above-described materials.

Mold insulation patterns 510 extending in the second direction Y and having line shapes may be disposed on the first conductive layer pattern 504 and the second lower insulation layer 506. The mold insulation pattern 510 may be disposed to cross the first conductive layer pattern 504.

The mold insulation pattern 510 may include one insulation pattern or two or more insulation patterns stacked. In example embodiments, the mold insulation pattern 510 may have a structure in which a silicon nitride layer pattern 510a and a silicon oxide layer pattern 510b are stacked. In this case, the silicon oxide layer pattern 510b may be mostly used as a mold structure, and the silicon nitride layer pattern 510a may serve as a lower etch stop layer. Therefore, a thickness of the silicon nitride layer pattern 510a may be less than a thickness of the silicon oxide layer pattern 510b.

The oxide semiconductor layer pattern 524 may be formed conformally along profiles of a sidewall of the mold insulation pattern 510 and an upper surface of the first conductive layer pattern 504 between the mold insulation patterns 510. The oxide semiconductor layer pattern 524 may have a U-shape, in a cross-sectional view cut in the first direction.

A bottom surface of the oxide semiconductor layer pattern 524 may contact an upper surface of the first conductive layer pattern 504.

The oxide semiconductor layer patterns 524 may be spaced apart from each other in the second direction Y. The mold insulation pattern 510 may be disposed between the oxide semiconductor layer patterns 524 in the first direction X, and the oxide semiconductor layer patterns 524 may be arranged in the first direction X.

In example embodiments, the oxide semiconductor layer pattern 524 may be amorphous. In example embodiments, the oxide semiconductor layer pattern 524 may include, e.g., InxGayZnzO, InxGaySizO, InxSnyZnzO, InxZnyO, ZnxO, ZnxSnyO, ZnxOyN, ZrxZnySnzO, SnxO, HfxInyZnzO, GaxZnySnzO, AlxZnySnzO, YbxGayZnzO, InxGayO or a combination thereof. For example, the oxide semiconductor layer pattern 524 may include InxGayZnzO.

The gate insulation layer pattern and the second conductive layer pattern 570 may be stacked on a sidewall of the mold insulation pattern 510. The second conductive layer pattern 570 may extend in the second direction Y.

The gate insulation layer pattern may include metal oxide. The second conductive layer pattern 570 may serve as a gate electrode of a vertical channel transistor. Additionally, the second conductive layer pattern 570 may extend in the second direction Y, and may serve as a word line of the semiconductor device.

The oxide semiconductor layer pattern 524 may serve as an isolated active pattern, and two vertical channel transistors connected in series may be disposed on the active pattern.

The second conductive layer pattern 570 may include doped polysilicon, metal, conductive metal nitride, conductive metal silicide, conductive metal oxide, or a combination thereof. The second conductive layer pattern 570 may include, e.g., doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or a combination thereof, but may not be limited thereto.

The first insulation layer pattern 580 may be formed on the second conductive layer pattern 570, the second lower insulation layer 506, the gate insulation layer pattern, and the mold insulation patterns 510, and the first insulation layer pattern 580 may fill a space between the mold insulation patterns 510. An upper surface of the first insulation layer pattern 580 may be coplanar with an uppermost surface of the second conductive layer pattern 570, or may be lower than the uppermost surface of the second conductive layer pattern 570.

A capping layer pattern 584 may be formed on the upper surface of the first insulation layer pattern 580 and the uppermost surface of the second conductive layer pattern 570. In example embodiments, an upper surface of the capping layer pattern 584 may be coplanar with an upper surface of the mold insulation pattern 510.

In example embodiments, the first insulation layer pattern 580 may include silicon oxide. The capping layer pattern 584 may include, e.g., silicon nitride.

The third conductive layer pattern 590 may contact an end of the oxide semiconductor layer pattern 524. That is, the third conductive layer pattern 590 may contact an uppermost surface of the oxide semiconductor layer pattern 524.

The third conductive layer patterns 590 may include a first portion vertically extending from the same level as the uppermost surface of the capping layer pattern 584 to the uppermost surface of the oxide semiconductor layer pattern 524, and a second portion connected to the first portion and disposed on the capping layer pattern 584 and the mold insulation pattern 510. The third conductive layer pattern 590 may serve as a pad conductive pattern (e.g., landing pad) to be connected to the capacitor 160.

The third conductive layer pattern 590 may include doped polysilicon, metal, conductive metal nitride, conductive metal silicide, conductive metal oxide, or a combination thereof. The third conductive layer pattern 590 may include, e.g., doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or a combination thereof, but may not be limited thereto.

A second insulation layer pattern 592 may be disposed between the third conductive layer patterns 590. Upper surfaces of the third conductive layer patterns 590 and the second insulation layer patterns 592 may be coplanar with each other. The second insulation layer pattern 592 may include, e.g., silicon oxide.

The etch stop layer 106 may be disposed on the second insulation layer pattern 592 and the third conductive layer pattern 590. The etch stop layer 106 may include, e.g., silicon nitride.

The capacitor 160 may pass through the etch stop layer 106, and may contact an upper surface of the third conductive layer pattern 590.

The capacitor 160 includes the primary lower electrode 130, the interface structure 140, the primary dielectric layer 142, and the upper electrode 150. A bottom of the primary lower electrode 130 may contact the third conductive layer pattern 590serving as a landing pad. The plate electrode 152 may be formed on the upper electrode 150.

In example embodiments, the capacitor 160 may be substantially the same as the capacitor described with reference to FIG. 1. In some example embodiments, the capacitor may be substantially the same as the capacitor described with reference to FIG. 12.

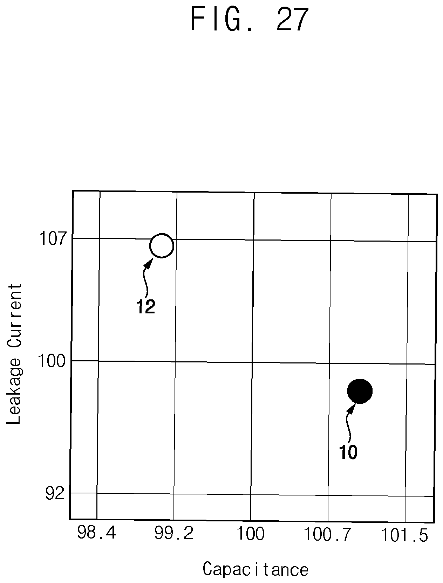

FIG. 27 is a graph of capacitances and leakage current characteristics of a capacitor according to an embodiment of the invention and a capacitor according to a comparative example.

An X-axis represents a normalized value of an electrostatic capacitance, and a Y-axis represents a normalized value of leakage currents.

In FIG. 27, the capacitor according to the embodiment includes an interface structure in which a first interface layer including titanium oxide doped with Nb on a primary lower electrode including TiN, a second interface layer including titanium oxide doped with Nb and nitrogen, and a third interface layer including zirconium oxide doped with nitrogen are stacked. A primary dielectric layer including zirconium oxide is formed on the interface structure. An upper electrode including TiN is formed on the primary dielectric layer.

The capacitor according to the comparative example has the same structure as the capacitor according to the example, except that a single interface layer including Nb-doped titanium oxide is formed on the primary lower electrode.

A sum of thicknesses of the interface structure and the primary dielectric layer included in the capacitor according to the embodiment is substantially the same as a sum of the thicknesses of the interface layer and the primary dielectric layer included in the capacitor according to the comparative example. Additionally, a sum of the thicknesses of the third interface layer and the primary dielectric layer included in the capacitor according to the embodiment is substantially the same as the thickness of the primary dielectric layer included in the capacitor according to the comparative example.

Referring to FIG. 27, a reference numeral 10 represents a capacitance and leakage currents of the capacitor according to the embodiment, and a reference numeral 12 represents a capacitance and leakage currents of the capacitor according to the comparative example.

As shown in FIG. 27, the capacitance of the capacitor according to the embodiment of the invention is higher than the capacitance of the capacitor according to the comparative example. Additionally, the leakage currents of the capacitor according to the embodiment is lower than the leakage currents of the capacitor according to the comparative example.

Accordingly, the capacitor according to embodiment has improved electrical characteristics.

Embodiments are set out in the following clauses:
Clause 1. A semiconductor device, comprising:
   conductive patterns and an etch stop layer on a substrate;
   primary lower electrodes passing through the etch stop layer, the primary lower electrodes contacting corresponding ones of the conductive patterns;
   a first interface layer contacting surfaces of the primary lower electrodes, the first interface layer including titanium oxide doped with a pentavalent element;
   a second interface layer on the first interface layer, the second interface layer including titanium oxide doped with a pentavalent element and nitrogen;
   a third interface layer on the second interface layer and the etch stop layer, the third interface layer including a first metal oxide doped with nitrogen, wherein a metal included in the first metal oxide of the third interface layer includes a tetravalent metal;
   a primary dielectric layer including a second metal oxide of a tetravalent metal on the third interface layer; and
   an upper electrode on the primary dielectric layer.
Clause 2. The semiconductor device of clause 1, wherein the third interface layer includes nitrogen-doped hafnium oxide or nitrogen-doped zirconium oxide.
Clause 3. The semiconductor device of claim 1 or clause 2, wherein a nitrogen concentration of an interface structure including the first interface layer, the second interface layer and the third interface layer gradually increases and then gradually decreases in a direction from a top surface of each primary lower electrode toward the primary dielectric layer.
Clause 4. The semiconductor device of any preceding clause, wherein a nitrogen concentration of the third interface layer is less than 10 atomic %.
Clause 5. A semiconductor device, comprising:
   a cell transistor on a substrate, the cell transistor including a gate structure;
   a bit line structure electrically connected to a portion of the substrate;
   conductive patterns on the bit line structure, the conductive patterns electrically connected to a portion of the substrate; and
   a plurality of capacitors respectively on the conductive patterns,
   wherein each of the capacitors includes:
      a primary lower electrode contacting a corresponding one of the conductive patterns;
      an interface structure on a surface of the primary lower electrode, the interface structure including a first interface layer, a second interface layer, and a third interface layer sequentially stacked;
      a primary dielectric layer on the interface structure, the primary dielectric layer including a metal oxide of a tetravalent metal; and
      an upper electrode on the primary dielectric layer, and
      wherein the first and second interface layers include a conductive metal oxide, and the third interface layer includes a nitrogen-doped metal oxide, and a metal included in the third interface layer is a different metal from a metal included in the first and second interface layers.
Clause 6. The semiconductor device of clause 5, further comprising a support layer pattern surrounding a portion of the surface of the primary lower electrode.
Clause 7. The semiconductor device of clause 6, wherein the first interface layer and the second interface layer are formed only along surfaces of the primary lower electrodes of the plurality of the capacitors, and the third interface layer is continuously formed on the second interface layer, the support layer pattern, and an area between the primary lower electrodes of the plurality of the capacitors.
Clause 8. The semiconductor device of any of clauses 5-7, further comprising a plate electrode on the upper electrode, the plate electrode filling a space between the primary lower electrodes of the plurality of the capacitors.
Clause 9. A method of forming a capacitor comprising:
   forming a primary lower electrode including metal on a substrate;
   forming a first preliminary interface layer including a first metal oxide doped with a pentavalent element on a surface of the primary lower electrode;
   forming a second preliminary interface layer including a second metal oxide including a tetravalent metal on the first preliminary interface layer;
   doping nitrogen into the second preliminary interface layer and an upper portion of the first preliminary interface layer to form an interface structure including a first interface layer including the first metal oxide doped with the pentavalent element on the surface of the primary lower electrode, a second interface layer including the first metal oxide further doped with the pentavalent element and nitrogen, and a third interface layer including a third metal oxide of a tetravalent metal doped with nitrogen;
   forming a primary dielectric layer on the interface structure; and
   forming an upper electrode on the primary dielectric layer.
Clause 10. The method of clause 9, wherein the pentavalent element includes vanadium (V), niobium (Nb), tantalum (Ta), antimony (Sb), or phosphorus (P).
Clause 11. The method of clause 9 or clause 10, wherein the first metal oxide is formed by natural oxidation on a surface of the primary lower electrode.
Clause 12. The method of clause 11, wherein forming the first preliminary interface layer comprises:
   forming a preliminary metal oxide layer including the first metal oxide on the substrate and the primary lower electrode;
   forming a reaction layer including a pentavalent element on the preliminary metal oxide layer;
   performing a heat treatment process on the reaction layer to form the first preliminary interface layer by diffusing the pentavalent element included in the reaction layer into the preliminary metal oxide layer; and
   removing the reaction layer on the substrate.
Clause 13. The method of clause 12, wherein the removing of the reaction layer is performed by isotropic etching process.
Clause 14. The method of any of clauses 9-13, wherein the second preliminary interface layer is continuously formed on the first preliminary interface layer and the substrate.
Clause 15. The method of any of clause 9-14, wherein the second preliminary interface layer includes hafnium oxide or zirconium oxide.
Clause 16. The method of any of clauses 9-15, wherein doping nitrogen into the second preliminary interface layer and the upper portion of the first preliminary interface layer is performed by performing a heat treatment or plasma treatment process while introducing nitrogen gas.
Clause 17. The method of any of clauses 9-16 further comprising performing subsequent processes after doping nitrogen into the second preliminary interface layer and the upper portion of the first preliminary interface layer, and a nitrogen concentration of the third interface layer is less than 10 atomic % after performing the subsequent processes.
Clause 18. The method of any of clauses 9-17, wherein the primary dielectric layer includes a metal oxide including a tetravalent metal.
Clause 19. The method of any of clauses 9-18, wherein the primary dielectric layer is formed to include hafnium oxide, zirconium oxide, or aluminum oxide.
Clause 20. The method of any of clauses 9-19, wherein a thickness of the primary dielectric layer is greater than a thickness of the interface structure.
Clause 21. The method of any of clauses 9-20, wherein a sum of a thicknesses of the primary dielectric layer and the third interface layer is 40Å to 60Å.
Clause 22. The method of any of clauses 9-21, wherein the primary lower electrode includes titanium nitride, and the first preliminary interface layer includes titanium oxide doped with the pentavalent element.
Clause 23. A semiconductor device, comprising:
   a substrate;
   conductive patterns on the substrate; and
   a capacitor on each of the conductive patterns,
   wherein each capacitor includes:
      a primary lower electrode contacting a corresponding one of the conductive patterns;
      an interface structure on a surface of the primary lower electrode;
      a primary dielectric layer on the interface structure, the primary dielectric layer including a first metal oxide; and
      an upper electrode on the primary dielectric layer,
      wherein the interface structure includes:
         a first interface layer on the primary lower electrode, the first interface layer including a second metal oxide;
         a second interface layer on the first interface layer, the second interface layer including the second metal oxide; and
         a third interface layer on the second interface layer, the third interface layer including a third metal oxide,
         wherein the primary lower electrode, the first interface layer and the second interface layer function as an electrode of the capacitor, and the third interface layer and the primary dielectric layer function as a dielectric of the capacitor;
         wherein each of the first interface layer and the second interface layer is a part of a monolithic layer, and a nitrogen concentration of the second interface layer is higher than a nitrogen concentration of the first interface layer; and
         wherein a nitrogen concentration of the third interface layer is higher than a nitrogen concentration of the primary dielectric layer.
Clause 24. The semiconductor device of clause 23, wherein a nitrogen concentration of the interface structure gradually increases and then gradually decreases in a direction from a top upper surface of the primary lower electrode toward the primary dielectric layer.
Clause 25. The semiconductor device of clause 23 or clause 24, wherein a first portion of the primary dielectric layer contacts an upper surface of the third interface layer, and the third metal oxide in the first portion of the primary dielectric layer is the same as the second metal oxide.
Clause 26. The semiconductor device of any of clauses 23-25, wherein the first and second interface layers include dopants of a pentavalent element.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

Ordinal numbers such as "primary," "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

Although example embodiments of the present disclosure have been described above, it will be understood by those of ordinary skill in the art that various changes and modifications can be made to the present disclosure without departing from the idea and scope of the present disclosure as set forth in the appended claims.

## Claims

1. A capacitor, comprising:
a primary lower electrode;
an interface structure on a surface of the primary lower electrode;
a primary dielectric layer on the interface structure, the primary dielectric layer including a first metal oxide; and
an upper electrode on the primary dielectric layer,
wherein the interface structure includes:
a first interface layer having electrical conductivity, the first interface layer including a second metal oxide and dopants of a pentavalent element;
a second interface layer on the first interface layer, the second interface layer including the second metal oxide and dopants of nitrogen; and
a third interface layer on the second interface layer, the third interface layer including a third metal oxide and dopants of nitrogen, wherein the third metal oxide includes an oxide of a tetravalent metal.

2. The capacitor of claim 1, wherein the pentavalent element includes vanadium, niobium, tantalum, antimony, or phosphorus.

3. The capacitor of claim 1 or claim 2, wherein the primary lower electrode includes metal or metal nitride, and a metal included in the second metal oxide of the first interface layer is the same as a metal included in the primary lower electrode.

4. The capacitor of any preceding claim, wherein the first interface layer includes titanium oxide doped with a pentavalent element, and the second interface layer includes titanium oxide doped with the pentavalent element and nitrogen.

5. The capacitor of any preceding claim, wherein the third interface layer includes nitrogen-doped hafnium oxide or nitrogen-doped zirconium oxide.

6. The capacitor of any preceding claim, wherein a nitrogen concentration of the second interface layer is higher than a nitrogen concentration of the third interface layer.

7. The capacitor of any preceding claim, wherein a nitrogen concentration of the interface structure gradually increases and then gradually decreases in a direction from a top upper surface of the primary lower electrode toward the primary dielectric layer.

8. The capacitor of any preceding claim, wherein a nitrogen concentration of the third interface layer is less than 10 atomic %.

9. The capacitor of any preceding claim, wherein the primary dielectric layer includes a metal oxide including a tetravalent metal.

10. The capacitor of any preceding claim, wherein the primary dielectric layer includes zirconium oxide, hafnium oxide, or aluminum oxide.

11. The capacitor of any preceding claim, wherein each of the first and second interface layers has a thickness of 5Å to 10Å, and the third interface layer has a thickness of 5Å to 15Å.

12. The capacitor of any preceding claim, wherein a sum of thicknesses of the third interface layer and the primary dielectric layer is 40Å to 60Å.

13. A semiconductor device, comprising:
conductive patterns and an etch stop layer on a substrate;
primary lower electrodes passing through the etch stop layer, the primary lower electrodes contacting corresponding ones of the conductive patterns;
a first interface layer contacting surfaces of the primary lower electrodes, the first interface layer including titanium oxide doped with a pentavalent element;
a second interface layer on the first interface layer, the second interface layer including titanium oxide doped with a pentavalent element and nitrogen;
a third interface layer on the second interface layer and the etch stop layer, the third interface layer including a first metal oxide doped with nitrogen, wherein a metal included in the first metal oxide of the third interface layer includes a tetravalent metal;
a primary dielectric layer including a second metal oxide of a tetravalent metal on the third interface layer; and
an upper electrode on the primary dielectric layer.

14. The semiconductor device of claim 13, wherein the third interface layer includes nitrogen-doped hafnium oxide or nitrogen-doped zirconium oxide.

15. The semiconductor device of claim 13 or claim 14, wherein a nitrogen concentration of the third interface layer is less than 10 atomic %.
